# EUROPÄISCHE PATENTANMELDUNG

(11) **EP 3 225 854 A1**
(43) Veröffentlichungstag der Anmeldung: **04.10.2017**
(21) Anmeldenummer: 17150987.0
(22) Anmeldetag: 11.01.2017
(51) Int. Cl.: F15B 15/28, G06K 19/06, G01B 11/02, G01D 5/244, H03M 1/28

(54) **HYDRAULIKZYLINDER FÜR EINE LANDWIRTSCHAFTLICHE ARBEITSMASCHINE**

(30) Priorität: 01.04.2016 DE 102016105961
(71) Anmelder: CLAAS Hungaria Kft., 5200 Törökszentmiklos (HU)
(72) Erfinder: Gamble, Sebastian, 5000 Szolnok (HU)
(74) Vertreter: Budach, Steffen

(57) **Zusammenfassung**

Die Erfindung betrifft einen Hydraulikzylinder für eine landwirtschaftliche Arbeitsmaschine (2) mit einer Zylindereinheit (3) und einem in der Zylindereinheit über eine Hublänge laufenden Kolben (3) mit einer geometrischen Kolbenlängsachse, wobei der Kolben durch in die Zylindereinheit eingeleiteten Hydraulikdruck antreibbar ist, wobei sich zum Ausleiten von Antriebskraft von dem Kolben eine Kolbenstange (7) durch die Zylindereinheit hindurch erstreckt, wobei an der Zylindereinheit eine optische Messanordnung (16) vorgesehen ist und wobei an der Kolbenstange mindestens eine Messmarkierung (17) vorgesehen ist, die bei einer Verstellung der Kolbenstange an der Messanordnung vorbeiläuft und von der Messanordnung zur Ermittlung der Kolbenstellung erfassbar ist. Es wird vorgeschlagen, dass die Messmarkierung durch die Wärmebehandlung des Anlassens, insbesondere Laseranlassens, an der Oberfläche der Kolbenstange erzeugt ist und dass die Messanordnung in einem Bereich angeordnet ist, der frei von dem in der Zylindereinheit jeweils wirkenden Hydraulikdruck ist.

## Beschreibung

Die Erfindung betrifft einen Hydraulikzylinder für eine landwirtschaftliche Arbeitsmaschine gemäß dem Oberbegriff von Anspruch 1 sowie eine landwirtschaftliche Arbeitsmaschine mit einem solchen Hydraulikzylinder gemäß Anspruch 15.

Der Begriff "landwirtschaftliche Arbeitsmaschine" ist vorliegend weit zu verstehen. Er umfasst Erntemaschinen wie Feldhäcksler oder Mähdrescher, die selbstfahrend oder nicht selbstfahrend ausgestaltet sein können, Anbaugeräte, Traktoren o. dgl.

Die in Rede stehende, landwirtschaftliche Arbeitsmaschine weist regelmäßig eine Mehrzahl von Hydraulikzylindern auf, die sich als kompakte und gleichzeitig robuste Stellantriebe bewährt haben. Ein solcher Hydraulikzylinder weist eine Zylindereinheit und einen in der Zylindereinheit über eine Hublänge laufenden Kolben auf. Um den Stellantrieb im Rahmen eines Regelprozesses einsetzen zu können, ist eine zuverlässige Erfassung der Kolbenstellung des Hydraulikzylinders erforderlich. Hierfür sind eine ganze Reihe von Ansätzen bekannt geworden, deren Integration in einen Hydraulikzylinder allerdings stets eine Änderung dessen strukturellen Aufbaus erforderlich machen. Dabei handelt es sich speziell um Messanordnungen, die im Druckraum der Zylindereinheit des Hydraulikzylinders platziert sind.

Bei dem bekannten Hydraulikzylinder (WO 2006/066161 A1), von dem die Erfindung ausgeht, ist an der Zylindereinheit eine optische Messanordnung vorgesehen, die eine Messmarkierung an einer dem Kolben zugeordneten Kolbenstange erfasst. Die Messanordnung ist hier ein Barcode, der pixelweise in die Oberfläche der Kolbenstange eingebracht worden ist. Ein Pixel ist hier eine Vertiefung, die mittels eines laserbasierten, abtragenden Verfahrens erzeugt worden ist. Die Messanordnung ist in den Zylinderkopf der Zylindereinheit integriert.

Die Messanordnung des bekannten Hydraulikzylinders ist insoweit nachteilig, als die pixelweisen Vertiefungen in der Oberfläche der Kolbenstange eine entsprechende Anpassung der Kolbendichtungen erforderlich machen, um zu vermeiden, dass die Dichtheit und insbesondere die Lebensdauer des Hydraulikzylinders beeinträchtigt werden. Die Platzierung der Messanordnung im Zylinderkopf erfordert ebenfalls einen Eingriff in den strukturellen Aufbau des Hydraulikzylinders, so dass der bekannte Hydraulikzylinder insgesamt kostentechnisch optimierbar ist.

Der Erfindung liegt das Problem zugrunde, den bekannten Hydraulikzylinder derart auszugestalten und weiterzubilden, dass sich die Kolbenstellung genau und gleichzeitig mit einem kostengünstigen Aufbau erfassen lässt.

Das obige Problem wird bei einem Hydraulikzylinder gemäß dem Oberbegriff von Anspruch 1 durch die Merkmale des kennzeichnenden Teils von Anspruch 1 gelöst.

Wesentlich ist die Überlegung, dass die Messanordnung zur Ermittlung der Kolbenstellung für eine kostengünstige Anordnung so ausgestaltet sein muss, dass die Antriebsfunktion des Hydraulikzylinders durch die Messanordnung nicht beeinflusst wird. Dies wird vorschlagsgemäß zunächst einmal dadurch realisiert, dass die Messmarkierung durch die Wärmebehandlung des Anlassens an der Oberfläche der Kolbenstange erzeugt ist, ohne dass es dabei zu einem Abtragen von Material kommt. Die Überlegung dabei besteht darin, dass speziell Metalle bei der Wärmebehandlung des Anlassens charakteristische Anlassfarben annehmen. Dies wird vorliegend bei der Erzeugung der Messmarkierung genutzt. Wesentlich dabei ist die Tatsache, dass die Vermeidung des Materialabtrags dazu führt, dass die Oberflächentopologie der Kolbenstange durch die Erzeugung der Messmarkierung nicht beeinflusst wird, so dass insbesondere die Auslegung von Dichtungen zwischen Zylindereinheit und Kolben keiner Anpassung bedarf.

Zusätzlich wird vorgeschlagen, dass die Messanordnung in einem Bereich angeordnet ist, der frei von dem in der Zylindereinheit jeweils wirkenden Hydraulikdruck ist. Dies ermöglicht die Platzierung der Messanordnung unabhängig, insbesondere separat, von dem Hydraulikzylinder im Übrigen. Dadurch ist das Innere der Zylindereinheit vollständig unbeeinflusst von der Realisierung der Messanordnung.

Im Ergebnis ergibt sich durch die vorschlagsgemäße Lösung die Möglichkeit der Integration einer Messanordnung zur Ermittlung der Kolbenstellung in einen Hydraulikzylinder, ohne den strukturellen Aufbau des Hydraulikzylinders auch nur ansatzweise verändern zu müssen. Das ist die Basis für eine kostengünstige Umsetzung einer solchen Messanordnung.

Die bevorzugten Ausgestaltungen gemäß den Ansprüchen 3 bis 6 betreffen Varianten für die Festlegung der Messanordnung am Hydraulikzylinder im Übrigen. Hier zeigt sich, dass die Messanordnung durch die vorschlagsgemäße Lösung weitgehend unabhängig von dem Hydraulikzylinder im Übrigen ausgelegt werden kann. Bei der weiter bevorzugten Ausgestaltung gemäß Anspruch 6 ist es sogar so, dass der Messträger, der die Messanordnung aufnimmt, lediglich an die Zylindereinheit angesetzt oder auf die Zylindereinheit aufgeschoben ist. Damit ist es sogar denkbar, dass ein bestehender Hydraulikzylinder mit der vorschlagsgemäßen Lösung nachgerüstet wird.

Die ebenfalls bevorzugten Ausgestaltungen gemäß den Ansprüchen 8 bis 11 betreffen Varianten für die Auslegung der Messanordnung mit einem optischen Sender zum Aussenden optischer Strahlung auf die Messmarkierung und mindestens einem optischen Sensor zur Erfassung der von der Messmarkierung reflektierten optischen Strahlung.

Bei der besonders bevorzugten Ausgestaltung gemäß Anspruch 10 handelt es sich bei dem optischen Sensor um einen Linearsensor, der als CCD-Linearsensor ausgestaltet ist. Dies führt zu einer besonders kostengünstigen Umsetzung des optischen Sensors. Bevorzugte Ausgestaltungen der Messmarkierung sind Gegenstand der Ansprüche 12 bis 14. Die bevorzugte Ausgestaltung gemäß Anspruch 12 ermöglicht den Aufbau eines mehrstelligen insbesondere binären Codes, indem die Spuren der Messmarkierung jeweils eine Stelle des Codes repräsentieren.

Bei der weiter bevorzugten Ausgestaltung gemäß Anspruch 13 ist in einer Variante erkannt worden, dass die Messmarkierung nicht durchgehend über die gesamte Länge der Kolbenstange vorgesehen sein muss, da in manchen Anwendungsfällen eine genaue Positionierung des Kolbens bspw. nur in den Endstellungen des Kolbens erforderlich ist. Dies kann insbesondere bei Hydraulikzylindern mit großer Hublänge zu einer weiteren Reduzierung der mit der Umsetzung der Messanordnung verbundenen Kosten führen.

Bei der weiter bevorzugten Ausgestaltung gemäß Anspruch 14 sind zwei Messmarkierungen vorgesehen, die eine doppelte Ermittlung der Kolbenstellung ermöglichen. Dies entspricht einer redundanten Ermittlung der Kolbenstellung, was bei sicherheitsrelevanten Anwendungen vorteilhaft sein kann. Eine solche sicherheitsrelevante Anwendung ist bspw. der Einsatz des vorschlagsgemäßen Hydraulikzylinders in einem Lenksystem.

Nach einer weiteren Lehre gemäß Anspruch 15, der eigenständige Bedeutung zukommt, wird eine landwirtschaftliche Arbeitsmaschine als solche beansprucht, die mit mindestens einem vorschlagsgemäßen Hydraulikantrieb ausgestattet ist. Auf alle Ausführungen zu dem vorschlagsgemäßen Hydraulikantrieb darf verwiesen werden.

Im Folgenden wird die Erfindung anhand einer lediglich Ausführungsbeispiele darstellenden Zeichnung näher erläutert. In der Zeichnung zeigt
- Fig. 1: eine vorschlagsgemäße landwirtschaftliche Arbeitsmaschine mit einem vorschlagsgemäßen Hydraulikzylinder in einer ganz schematischen Seitenansicht,
- Fig. 2: den Hydraulikzylinder gemäß Fig. 1 in einer ausschnittsweisen, teilweise geschnittenen Darstellung und
- Fig. 3: einen weiteren vorschlagsgemäßen Hydraulikzylinder in einer Darstellung gemäß Fig. 2.

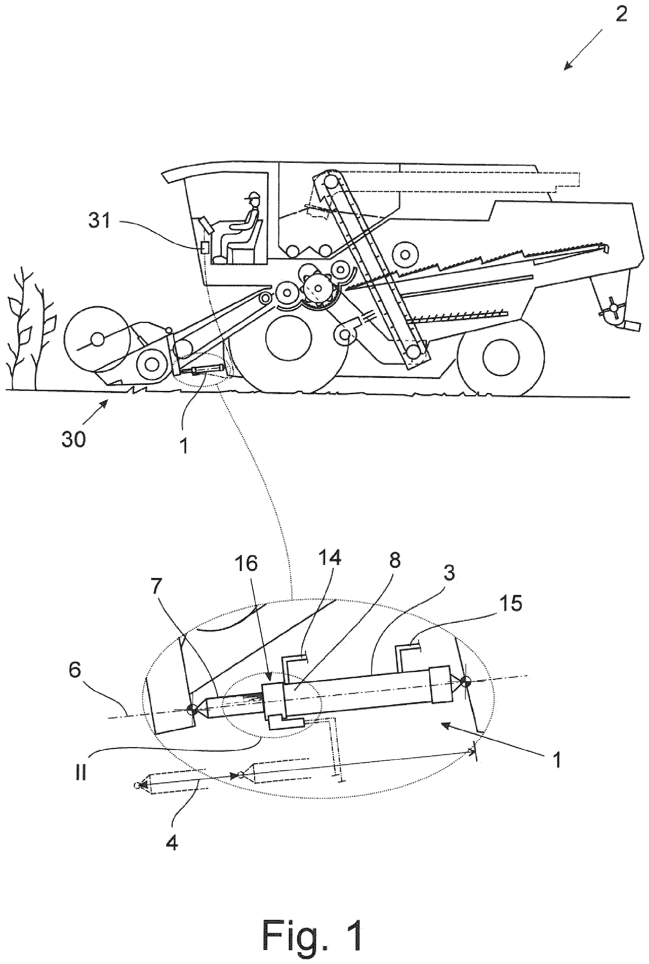

Der in Fig. 1 gezeigt Hydraulikzylinder 1 wird im Folgenden stellvertretend für andere Hydraulikzylinder der dortigen landwirtschaftlichen Arbeitsmaschine 2 erläutert. Alle Erläuterungen für diesen Hydraulikzylinder 1 gelten für alle eventuell vorgesehenen, nicht dargestellten Hydraulikzylinder entsprechend.

Die Detaildarstellung von Fig. 1 zeigt, dass der Hydraulikzylinder 1 eine Zylindereinheit 3 und einen in der Zylindereinheit 3 über eine Hublänge 4 laufenden Kolben 5 mit einer geometrischen Kolbenlängsachse 6 aufweist. Die Hublänge 4 ist hier definiert als der Weg des Kolbens 5 zwischen der vollständig eingefahrenen Stellung und der vollständig ausgefahrenen Stellung des Hydraulikzylinders 1.

Der Kolben 5 ist durch einen in die Zylindereinheit 3 eingeleiteten Hydraulikdruck antreibbar. Der Hydraulikdruck ist hier der Druck einer Hydraulikflüssigkeit, insbesondere eines Hydrauliköls, der in die Zylindereinheit 3 gepumpt wird. Zum Ausleiten von Antriebskraft ist eine Kolbenstange 7 vorgesehen, die mit dem Kolben 5 verbunden ist und die sich durch die Zylindereinheit 3 hindurch erstreckt. Hierfür weist ein Zylinderkopf 8 der Zylindereinheit 3 eine Zylinderöffnung 9 auf, durch die sich die Kolbenstange 7 hindurch erstreckt. Der Kolben 5 ist gegenüber der Zylinderöffnung 9 über eine druckfeste Dichtung 10 abgedichtet, um sicherzustellen, dass keine Hydraulikflüssigkeit aus der Zylindereinheit 3 austritt.

Bei dem dargestellten und insoweit bevorzugten Ausführungsbeispiel ist der Hydraulikzylinder 1 doppelt wirkend ausgestaltet. Dies bedeutet, dass der Kolben 5 dem Innenraum 11 der Zylindereinheit 3 in zwei Druckräume 12, 13 unterteilt, die jeweils über die Hydraulikflüssigkeit mit Hydraulikdruck beaufschlagbar sind. Hierfür sind die beiden Druckräume 12,13 jeweils mit einem Hydraulikanschluss 14, 15 ausgestattet.

An der Zylindereinheit 3 ist eine optische Messanordnung 16 vorgesehen, wobei an der Kolbenstange 7 mindestens eine Messmarkierung 17 vorgesehen ist, die bei einer Verstellung der Kolbenstange 7 an der Messanordnung 16 vorbeiläuft und von der Messanordnung 16 zur Ermittlung der Kolbenstellung erfassbar ist. Die Kolbenstellung ist als die Stellung des Kolbens 5 relativ zu der Zylindereinheit 3 definiert.

Wesentlich ist nun, dass die Messmarkierung 17 durch die Wärmebehandlung des Anlassens, hier und vorzugsweise des Laseranlassens, an der Oberfläche der Kolbenstange 7 erzeugt ist. Wesentlich ist weiter, dass die Messanordnung 16 in einem Bereich angeordnet ist, der frei von dem in der Zylindereinheit 3 jeweils wirkenden Hydraulikdruck ist. Die hiermit verbundenen Vorteile wurden im allgemeinen Teil der Beschreibung bereits erläutert.

Insbesondere wurde bereits erläutert, dass mit dem Laseranlassen ein Materialabtrag der Kolbenstange 7 nicht stattfindet, sondern lediglich eine Änderung der optischen Reflektionseigenschaften an der jeweils angelassenen Stelle. Entsprechend ist eine Anhebung oder Absenkung der Oberfläche der Kolbenstange 7, die auf das Laseranlassen zurückgeht, bei besonders bevorzugter Auslegung nicht vorgesehen. Jedenfalls liegt eine solche Anhebung oder Absenkung der Oberfläche der Kolbenstange 7 bei weniger als 10 µm.

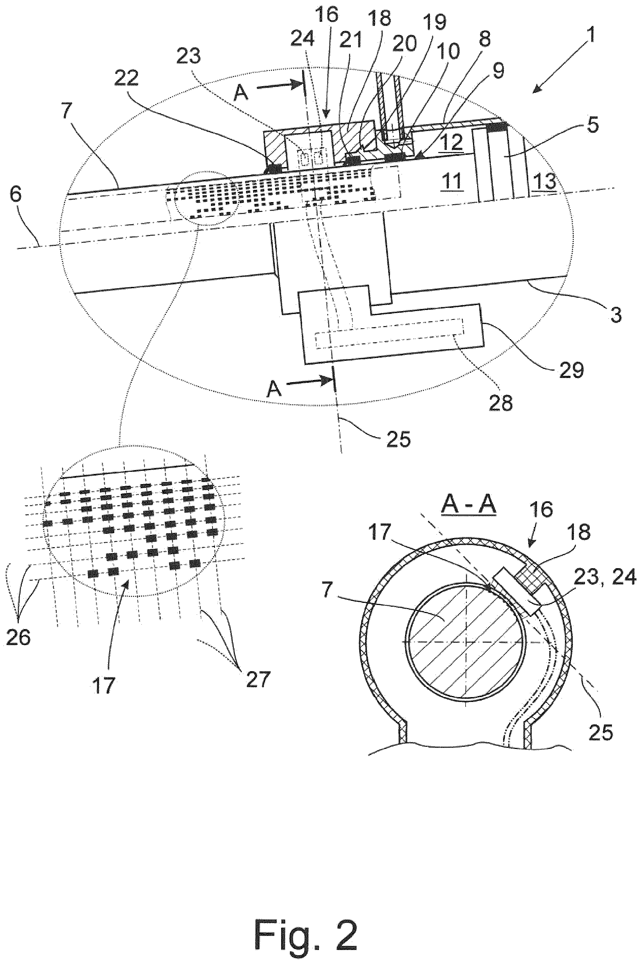

Fig. 2 zeigt, dass hier und vorzugsweise ein Messträger 18 vorgesehen ist, der die Messanordnung 16 aufnimmt, wobei der Messträger 18 frei von dem in der Zylindereinheit 3 jeweils wirkenden Hydraulikdruck ist. Entsprechend lässt sich der Messträger 18 an dem Hydraulikzylinder 1 im Übrigen anbringen, ohne dass der Hydraulikzylinder 1 in seinem strukturellen Aufbau verändert werden muss. Der in Fig. 2 gezeigte Messträger 8 ist montagetechnisch insoweit besonders vorteilhaft, als der Messträger 18 ringförmig ausgestaltet ist. Der ringförmige Messträger 18 ist koaxial zu der Kolbenlängsachse 6 ausgerichtet und umschließt zumindest einen Teil der Zylindereinheit 3. Damit lässt sich der Messträger 18 auf einfache Weise kraft- und/oder formschlüssig mit der Zylindereinheit 3, insbesondere mit der Außenfläche der Zylindereinheit 3, koppeln.

Die ringförmige Ausgestaltung des Messträgers 18 bedeutet nicht notwendigerweise, dass der Messträger 18 einstückig ausgestaltet ist. Denkbar ist bspw., dass der Messträger 18 zwei Halbschalen aufweist, die sich zu einer Ringform ergänzen. Ganz allgemein ist es vorzugsweise so, dass der Messträger 18 an die Zylindereinheit 3 angesetzt oder auf die Zylindereinheit 3 aufgeschoben ist. Das Aufschieben erfolgt vorzugsweise entlang der Kolbenlängsachse 6.

Bei allen denkbaren strukturellen Ausgestaltungen des Messträgers 18 ist der Messträger 18 vorzugsweise mit der Zylindereinheit 3 verrastet. Dies ist in Fig. 2 dadurch angedeutet, dass der Messträger 18 eine Rastausformung 19 aufweist, die mit einer Gegenrastausformung 20 der Zylindereinheit 3 in Eingriff steht. Dabei ist die Rastausformung 19 vorzugsweise nachgiebig ausgestaltet, so dass das Ansetzen oder Aufschieben des Messträgers 18 an bzw. auf die Zylindereinheit 3 mit einer entsprechenden Verformung der Rastausformung 19 und im Ergebnis mit dem obigen Verrasten des Messträgers 18 mit der Zylindereinheit 3 einhergeht.

Vorzugsweise weist die Kolbenstange 7 eine Hartchrom-Oberfläche auf, in die durch das vorschlagsgemäße Laseranlassen die Messmarkierung 17 eingebracht ist. Hier hat sich in Versuchen gezeigt, das sich eine solche Hartchrom-Oberfläche mit einer Messmarkierung 17 durch Laseranlassen versehen lässt, ohne dass dies die mechanischen Eigenschaften der Oberfläche der Kolbenstange 7 nennenswert beeinträchtigt. Im Übrigen ist die Kolbenstange 7 vorzugsweise aus einem Stahlmaterial ausgebildet.

Der grundsätzliche Aufbau der Messanordnung 16 lässt sich der Darstellung gemäß Fig. 2 entnehmen. Bei der Messanordnung 16 handelt es sich um eine optische Messanordnung, die dazu eingerichtet ist, die Messmarkierung 17 optisch zu erfassen. Dabei kann die Messanordnung 16 grundsätzlich eine Abtastung der Messmarkierung 17 mit optischer Infrarotstrahlung, Laserstrahlung oder sichtbarer Lichtstrahlung vornehmen.

Fig. 2 zeigt, dass die Messanordnung 16 hier und vorzugsweise zwischen einem ersten Abstreifer 21 und einem zweiten Abstreifer 22 angeordnet ist, so dass die Messanordnung 16 sowohl zur Zylindereinheit 3 hin als auch nach außen hin gegenüber dem Eintritt von Verunreinigungen geschützt ist. Der erste Abstreifer 21 ist dabei vorzugsweise an der Zylindereinheit 3 angeordnet, während der zweite Abstreifer 22 am Messträger 18 angeordnet ist. Die Messanordnung 16 befindet sich entlang der Kolbenlängsachse 6 gesehen zwischen den beiden Abstreifern 21, 22.

Die Messanordnung 16 weist hier und vorzugsweise mindestens einen optischen Sender 23 zum Aussenden optischer Strahlung auf die Messmarkierung 17 und mindestens einen optischen Sensor 24 zur Erfassung der von der Messmarkierung 17 reflektierten optischen Strahlung auf. Der optische Sensor 24 dient hier entsprechend als optischer Empfänger. Vorzugsweise sind sowohl der Sender als auch der Empfänger LED-basiert ausgestaltet, wobei grundsätzlich jegliche Arten optischer Strahlung zur Anwendung kommen können.

Die Querschnittsdarstellung gemäß Fig. 2 zeigt, dass der optische Sensor 24 als Linearsensor ausgestaltet ist, der die reflektierte optische Strahlung entlang einer geometrischen Sensorlängsachse 25, hier und vorzugsweise eine Verteilung der Lichtintensität entlang der geometrischen Sensorlängsachse 25, erfasst. Dabei ist es in einer besonders kostengünstigen und gleichzeitig kompakten Ausgestaltung vorgesehen, dass der Sensor 24 als CCD-Linearsensor ausgestaltet ist. Die Sensorlängsachse 25 des Sensors 24 ist hier und vorzugsweise quer zu der Kolbenlängsachse 6 ausgerichtet, wie der Darstellung gemäß Fig. 2 zu entnehmen ist.

Die Messmarkierung 17 weist mindestens zwei Spuren 26, hier und vorzugsweise mehrere Spuren 26, auf, die sich nebeneinander und entlang der Kolbenlängsachse 6 erstrecken und die über zumindest einen axialen Abschnitt hinsichtlich der Kolbenstellung einen unterschiedlichen Informationsgehalt aufweisen. Dabei ist es vorzugsweise so, dass die Messanordnung 16 aus der Erfassung der Spuren 26 der Messmarkierung 17 die Kolbenstellung ermittelt. Interessant ist hier im Zusammenhang mit der Ausgestaltung des Sensors 24 als Linearsensor mit einer Sensorlängsachse 25, die quer zu der Kolbenlängsachse 6 ausgerichtet ist, dass sich die Spuren 26 der Messmarkierung 17 zeilenweise auslesen lassen. Entsprechend ist es so, dass die Messmarkierung 17 neben den Spuren 26 auch Zeilen 27 aufweist, die wiederum über zumindest einen axialen Abschnitt hinsichtlich der Kolbenstellung einen unterschiedlichen Informationsgehalt aufweisen.

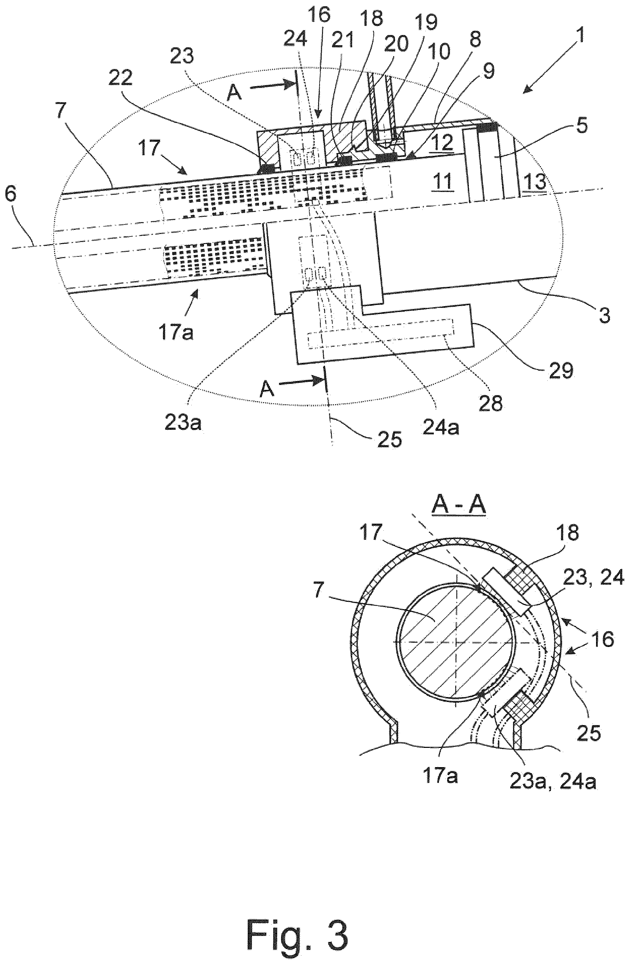

Insgesamt lässt sich aus den Spuren 26 und den Zeilen 27 über die Messmarkierung 17 eine Codierung in die Oberfläche der Kolbenstange 7 einbringen, die aus der Erfassung der Messmarkierung 17 entlang der Sensorlängsachse 25 die Ermittlung der absoluten Kolbenstellung ermöglicht. Dies allein durch die Einbringung unterschiedlicher optischer Reflektionseigenschaften an der entsprechenden Spur 26 und der entsprechenden Zeile 27 mittels der vorschlagsgemäßen Wärmebehandlung der Kolbenstange 7. Eine solche Codierung ist beispielhaft in den Fig. 2 und 3 zu erkennen.

Grundsätzlich kann die Messmarkierung 17 auch eine Strichcodierung nach Art eines Barcodes ausbilden. Hier und vorzugsweise ist es allerdings so, dass die Messmarkierung 17 eine binäre Codierung ausbildet, wobei die Spuren 26 einer jeden Zeile 27 ein Codewort ergeben. Dabei können unterschiedliche Arten einer binären Codierung zur Anwendung kommen. Nur beispielhaft sei hier die Anwendung eines Gray-Codes genannt, der eine besonders gute Robustheit gegenüber einer Fehlerfassung einzelner Teile der Messmarkierung 17 bietet.

Die Ermittlung der Kolbenstellung erfordert eine Auswerteeinheit 28, die zusammen mit dem Sender 23 und dem Sensor 24 in einem integrierten Bauteil untergebracht sein kann. Vorzugsweise ist es allerdings so, dass die Auswerteeinheit 28 separat von der Messanordnung 16 im Übrigen angeordnet ist. Dabei bildet die Auswerteeinheit 28 einen Bestandteil einer elektrischen Schnittstelle 29, die hier und vorzugsweise als Stecker ausgestaltet ist. Alternativ kann die elektrische Schnittstelle 29 auch als drahtlose Schnittstelle ausgestaltet sein.

Bei den dargestellten und insoweit bevorzugten Ausführungsbeispielen ist die Ermittlung der Kolbenstellung mittels der Messanordnung 16 über die gesamte Hublänge des Hydraulikzylinders 1 vorgesehen. Bei einer besonders kostengünstigen Ausgestaltung ist es jedoch so, dass die Ermittlung der Kolbenstellung mittels der Messanordnung 16 nur über mindestens einen Abschnitt der Hublänge vorgesehen ist, wobei in weiter bevorzugter Ausgestaltung die Kolbenstange 7 die mindestens eine Messmarkierung 17 nur über mindestens einen axialen Abschnitt der Kolbenstange 7 aufweist. Bspw. kann es vorteilhaft sein, dass die Ermittlung der Kolbenstellung nur im Bereich der beiden Endstellungen des Hydraulikzylinders 1 vorgesehen ist. Durch diese Vereinfachung der Messmarkierung 17 lässt sich eine beträchtliche Kosteneinsparung erreichen.

Fig. 3 zeigt eine weitere bevorzugte Ausführungsform, die eine besonders hohe Erfassungssicherheit für die Kolbenstellung bereitstellt, und zwar durch die Einbringung einer Redundanz bei der Ermittlung der Kolbenstellung. Hierfür ist bei dem in Fig. 3 dargestellten Ausführungsbeispiel eine zusätzliche Messmarkierung 17a vorgesehen, die ebenfalls von der Messanordnung 16 erfasst werden kann. Hierfür ist die Messanordnung 16 hier und vorzugsweise mit einem zusätzlichen optischen Sender 23a und einem zusätzlichen optischen Sensor 24a ausgestattet. Entsprechend ist es bei dem in Fig. 3 dargestellten Ausführungsbeispiel so, dass mindestens zwei, hier und vorzugsweise genau zwei, Messmarkierungen 17, 17a vorgesehen sind, die sich nebeneinander und entlang der Kolbenlängsachse der Kolbenlängsachse 6 erstrecken. Die Messanordnung 16 erfasst beide Messmarkierungen 17, 17a mittels der Sender 23, 23a und der Sensoren 24, 24a, woraus jeweils die Kolbenstellung ermittelt wird. Bei entsprechender Ausgestaltung der Messmarkierungen 17, 17a ist es möglich, die Kolbenstellung doppelt zu erfassen. Im einfachsten Fall sind die beiden Messmarkierungen 17, 17a identisch zueinander, so dass die Auswertung durch die Messanordnung 16 in identischer Weise doppelt erfolgt. Für den Fall, dass die beiden ermittelten Kolbenstellungen um mehr als eine vorbestimmte, zulässige Maximalabweichung voneinander abweisen, gibt die Messanordnung 16 eine entsprechende Fehlermeldung aus. Grundsätzlich kann es auch vorgesehen sein, dass sich die Messmarkierungen 17, 17a unterscheiden, insbesondere, dass die beiden Messmarkierungen 17, 17a unterschiedliche Codierungen enthalten. Auch hier können die beiden ermittelten Kolbenstellungen wiederum auf das Überschreiten einer vorbestimmten, zulässigen Maximalabweichung voneinander überprüft werden.

Nach einer weiteren Lehre, der eigenständige Bedeutung zukommt, wird eine landwirtschaftliche Arbeitsmaschine 2 als solche beansprucht, die mindestens einen oben angesprochenen, vorschlagsgemäßen Hydraulikzylinder 1 aufweist. Bei dem dargestellten und insoweit bevorzugten Ausführungsbeispiel ist die Arbeitsmaschine 2 als selbstfahrender Mähdrescher ausgestaltet, der mit einem Vorsatzgerät 30 ausgestattet ist. Bei dem Vorsatzgerät 30 handelt es sich vorzugsweise um ein Schneidwerk, das mittels des Hydraulikzylinders 1 angehoben oder abgesenkt werden kann. Der Mähdrescher ist vorzugsweise mit einem Fahrerassistenzsystem 31 ausgestattet, der das Vorsatzgerät 30 in Abhängigkeit von Vorfeldinformationen auf eine optimale Arbeitshöhe regelt. Für diese Regelung ist ein exaktes Anfahren der Kolbenstellung des Hydraulikzylinders 1 erforderlich, was sich mit der vorschlagsgemäßen Lösung auf kostengünstige und gleichzeitig robuste Weise realisieren lässt.

### Bezugszeichenliste

- 1: Hydraulikzylinder
- 2: Arbeitsmaschine
- 3: Zylindereinheit
- 4: Hublänge
- 5: Kolben
- 6: Kolbenlängsachse
- 7: Kolbenstange
- 8: Zylinderkopf
- 9: Zylinderöffnung
- 10: Dichtung
- 11: Innenraum
- 12: 1. Druckraum
- 13: 2. Druckraum
- 14: 1. Hydraulikanschluss
- 15: 2. Hydraulikanschluss
- 16: Messanordnung
- 17: Messmarkierung
- 18: Messträger
- 19: Rastausformung
- 20: Gegenrastausformung
- 21: erster Abstreifer
- 22: zweiter Abstreifer
- 23: 1. Sender
- 23a: 2. Sender
- 24: 1. Sensor
- 24a: 2. Sensor
- 25: Sensorlängsachse
- 26: Spuren
- 27: Zeilen
- 28: Auswerteeinheit
- 29: Schnittstelle
- 30: Vorsatzgeräte
- 31: Fahrerassistenzsystem

## Patentansprüche

1. Hydraulikzylinder für eine landwirtschaftliche Arbeitsmaschine (2) mit einer Zylindereinheit (3) und einem in der Zylindereinheit (3) über eine Hublänge (4) laufenden Kolben (5), dem eine geometrische Kolbenlängsachse (6) zugeordnet ist, wobei der Kolben (5) durch in die Zylindereinheit (3) eingeleiteten Hydraulikdruck antreibbar ist, wobei sich zum Ausleiten von Antriebskraft von dem Kolben (5) eine Kolbenstange (7) durch die Zylindereinheit (3) hindurch erstreckt, wobei an der Zylindereinheit (3) eine optische Messanordnung (16) vorgesehen ist und wobei an der Kolbenstange (7) mindestens eine Messmarkierung (17) vorgesehen ist, die bei einer Verstellung der Kolbenstange (7) an der Messanordnung (16) vorbeiläuft und von der Messanordnung (16) zur Ermittlung der Kolbenstellung erfassbar ist,
**dadurch gekennzeichnet,**
**dass** die Messmarkierung (17) durch die Wärmebehandlung des Anlassens, insbesondere Laseranlassens, an der Oberfläche der Kolbenstange (7) erzeugt ist und dass die Messanordnung (16) in einem Bereich angeordnet ist, der frei von dem in der Zylindereinheit jeweils wirkenden Hydraulikdruck ist.

2. Hydraulikzylinder nach Anspruch 1, **dadurch gekennzeichnet, dass** die durch das Anlassen erzeugte Messmarkierung (17) eine Anhebung oder Absenkung der Oberfläche der Kolbenstange (7) um weniger als 10µm, vorzugsweise keine Anhebung oder Absenkung der Oberflächen der Kolbenstange (7), erzeugt.

3. Hydraulikzylinder nach Anspruch 1 oder 2, **dadurch gekennzeichnet, dass** ein Messträger (18) vorgesehen ist, der die Messanordnung (16) aufnimmt und dass der Messträger (18) frei von dem in der Zylindereinheit (3) jeweils wirkenden Hydraulikdruck ist.

4. Hydraulikzylinder nach einem der vorhergehenden Ansprüche, **dadurch gekennzeichnet, dass** der Messträger (18) ringförmig ausgestaltet und koaxial zu der Kolbenlängsachse (6) ausgerichtet ist und dass der Messträger (18) zumindest einen Teil der Zylindereinheit (3) umschließt.

5. Hydraulikzylinder nach einem der vorhergehenden Ansprüche, **dadurch gekennzeichnet, dass** der Messträger (18) kraft- und/oder formschlüssig mit der Zylindereinheit (3), insbesondere mit einer Außenfläche der Zylindereinheit (3), gekoppelt ist.

6. Hydraulikzylinder nach einem der vorhergehenden Ansprüche, **dadurch gekennzeichnet, dass** der Messträger (18) an die Zylindereinheit (3) angesetzt oder auf die Zylindereinheit (3) aufgeschoben ist, vorzugsweise, dass der Messträger (18) mit der Zylindereinheit (3) verrastet ist.

7. Hydraulikzylinder nach einem der vorhergehenden Ansprüche, **dadurch gekennzeichnet, dass** die Kolbenstange (7) eine Hartchrom-Oberfläche aufweist, vorzugsweise, dass die Kolbenstange (7) im Übrigen aus einem Stahlmaterial ausgebildet ist.

8. Hydraulikzylinder nach einem der vorhergehenden Ansprüche, **dadurch gekennzeichnet, dass** die Messanordnung (16) mindestens einen optischen Sender (23) zum Aussenden optischer Strahlung auf die Messmarkierung (17) und mindestens einen optischen Sensor (24) zur Erfassung der von der Messmarkierung (17) reflektierten optischen Strahlung aufweist.

9. Hydraulikzylinder nach Anspruch 8, **dadurch gekennzeichnet, dass** der optische Sensor (24) als Linearsensor ausgestaltet ist, der die reflektierte optische Strahlung entlang einer geometrischen Sensorlängsachse (25), insbesondere eine Verteilung der Lichtintensität entlang der geometrischen Sensorlängsachse (25), erfasst.

10. Hydraulikzylinder nach Anspruch 8 oder 9, **dadurch gekennzeichnet, dass** der Sensor (24) als CCD-Linearsensor ausgestaltet ist.

11. Hydraulikzylinder nach einem der Ansprüche 8 bis 10, **dadurch gekennzeichnet, dass** die Sensorlängsachse (25) des Sensors (24) quer zu der Kolbenlängsachse ausgerichtet ist.

12. Hydraulikzylinder nach einem der vorhergehenden Ansprüche, **dadurch gekennzeichnet, dass** die Messmarkierung (17) mindestens zwei Spuren (26) aufweist, die sich nebeneinander und entlang der Kolbenlängsachse (6) erstrecken und die über zumindest einen axialen Abschnitt hinsichtlich der Kolbenstellung einen unterschiedlichen Informationsgehalt aufweisen, vorzugsweise, dass die Messanordnung (16) aus der Erfassung der Spuren (26) der Messmarkierung (17) die Kolbenstellung ermittelt.

13. Hydraulikzylinder nach einem der vorhergehenden Ansprüche, **dadurch gekennzeichnet, dass** die Ermittlung der Kolbenstellung mittels der Messanordnung (16) nur über mindestens einen Abschnitt der Hublänge (4) vorgesehen ist, vorzugsweise, dass die Kolbenstange (7) die mindestens eine Messmarkierung (17) nur über mindestens einen axialen Abschnitt der Kolbenstange (7) aufweist.

14. Hydraulikzylinder nach einem der vorhergehenden Ansprüche, **dadurch gekennzeichnet, dass** mindestens zwei Messmarkierungen (17, 17a) vorgesehen sind, die sich nebeneinander und entlang der Kolbenlängsachse (6) erstrecken und dass die Messanordnung (16) beide Messmarkierungen (17, 17a) erfasst und daraus jeweils die Kolbenstellung ermittelt, vorzugsweise, die Messanordnung (16) in dem Fall, dass die beiden ermittelten Kolbenstellungen um mehr als eine vorbestimmte, zulässige Maximalabweichung voneinander abweichen, eine Fehlermeldung ausgibt.

15. Landwirtschaftliche Arbeitsmaschine (2) mit mindestens einem Hydraulikzylinder (1) nach einem der vorhergehenden Ansprüche.
